# EUROPEAN PATENT APPLICATION

(11) **EP 2 621 256 A1**
(43) Date of publication of application: **31.07.2013**
(21) Application number: 11845874.4
(22) Date of filing: 05.01.2011
(51) Int. Cl.: H05K 7/20

(54) **PRINTED CIRCUIT BOARD WITH INSULATED MICRO RADIATOR**

(30) Priority: 30.11.2010 CN 201010564877
(71) Applicant: Rayben Technologies (Zhu Hai) Ltd, Zhuhai, Guangdong 519180 (CN)
(72) Inventor: WANG, Zheng, Zhuhai Guangdong 519180 (CN)
(74) Representative: Petraz, Gilberto Luigi
(86) International application number: PCT/CN2011/070042
(87) International publication number: WO 2012/071795

(57) **Abstract**

The invention relates to a printed circuit board (PCB) with an insulated micro radiator. The PCB comprises a PCB substrate, wherein the PCB substrate includes sequentially crossing laminated multi insulating layers clad with copper circuit layers and multi solidified insulating layers; the PCB with the insulated micro radiator further includes a cylindrical insulated micro radiator embedded in a cylindrical through hole of the PCB substrate; the height of the insulated micro radiator, with top and bottom surfaces both clad with the copper patterns, is equal to the thickness of the PCB substrate, wherein the top surface is provided with a heating component, and the bottom surface is insulated from the copper circuit layers of the PCB. The PCB has the advantages of high thermal conductivity and heat transfer stability of the insulated micro radiator as well as the advantages of flexible routing and reliable electrical connection of the conventional PCB. Moreover, it can transmit the heat generated by the heating component such as an LED and so on out of the PCB during operation, timely and effectively. Therefore, it is an ideal carrier board of the heating component and an array thereof.

## Description

### FIELD OF THE INVENTION

The invention relates to the technical field of a printed circuit board (PCB), in particular to a novel PCB combining an insulated micro radiator with a conventional PCB.

### BACKGROUND OF THE INVENTION

The printed circuit board (PCB) is one of the important components in the electronic industry. The PCB can provide a fixed and assembled mechanical support for electronic components and realize the electrical connection between the electronic components. Additionally, the PCB, printed with the legend of components and some graphics, provides convenience for soldering, inspecting and repairing the components. Almost every electronic device, whether which is a small one such as an electronic watch, a calculator and so on or which is a large one such as a computer, a telecommunication equipment, a military weapon system, shall use PCBs for their electrical connection as long as the electronic device contains the electronic components such as Integrated Circuits (ICs) and so on.

The conventional PCB adopts a Plated Through Hole (PTH) structure. The insulating material between copper layers is FR4 material. Its thermal conductivity is 0.4W/mk and it has relatively low heat transfer capability. As to a metal core PCB (MCPCB) developed in recent years, the thermal conductivity of the insulating material between metal layers is 1.3-2.2W/mk and it has still limited heat transfer capability. For a PCB provided with a large number of ICs, especially a PCB provided with a high-power light emitting diodes (LEDs), the heat generated by IC array or LED array during the operation is quite high and the specified operation temperature is low (about 60 degrees Celsius). Then the PCB thermal conductivity is required to be tens or hundreds of W / mk, obviously being far beyond the thermal conductivity of the insulating material in the prior art.

### SUMMARY OF THE INVENTION

To answer the PCB challenge in the prior art, the object of the invention is to provide a printed circuit board (PCB) with an insulated micro radiator.

The object of the invention is realized through the following technical proposal: A PCB with an insulated micro radiator, which includes a PCB substrate, wherein the PCB substrate includes sequentially crossing laminated multi insulating layers clad with copper circuit layers and multi solidified insulating layers; the PCB with the insulated micro radiator further includes a cylindrical insulated micro radiator embedded in a cylindrical through hole of the PCB substrate; the height of the insulated micro radiator, with top and bottom surfaces both clad with copper patterns, is equal to the thickness of the PCB substrate, wherein the top copper pattern is provided with a heating component, and the bottom copper pattern is insulated from the copper circuit layers.

As the preferable technical proposal of the invention, the insulated micro radiator is made of electrical insulating materials of alumina ceramic, aluminum nitride ceramic, silicon carbide, diamond, etc.

As the preferable technical proposal of the invention, the insulated micro radiator is in elliptical cylindrical shape, cube shape, or cylinder shape with its top and bottom surfaces both in diamond shape, triangular shape or trapezoidal shape.

As the preferable technical proposal of the invention, there is one or a number of the insulated micro radiators on the PCB.

As the preferable technical proposal of the invention, the heating component is a light emitting diode (LED) chip.

As the preferable technical proposal of the invention, the heating component is an LED component.

As the preferable technical proposal of the invention, the insulating layer clad with copper circuit layers is of which one surface is clad with the copper circuit layer.

As the preferable technical proposal of the invention, the insulating layer clad with copper circuit layers is of which top and bottom surfaces both are clad with the copper circuit layers.

As the preferable technical proposal of the invention, the heating component and the copper circuit layers are electrically connected.

As the preferable technical proposal of the invention, the PCB has four layers, six layers, eight layers or sixteen layers.

Compared with the prior art, the invention combines a high thermal conductivity insulated micro radiator with a conventional rigid PCB. The PCB has the advantages of high thermal conductivity and heat transfer stability of the insulated micro radiator as well as the advantages of flexible routing and reliable electrical connection of the conventional PCB. Moreover, it can transmit the heat generated by the heating component such as an LED and so on out of the PCB during operation, timely and effectively. Therefore, it is an ideal carrier board for the heating component and an array thereof.

### DRAWINGS OF THE INVENTION

The invention will be further described in more details with the combination of drawings and embodiments:

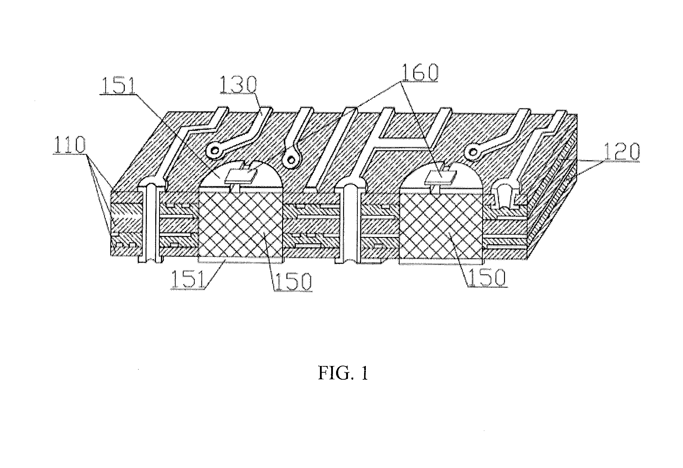

FIG.1 is a section diagram of a preferable embodiment of the invention.

### DETAILED DESCRIPTION OF THE INVENTION

FIG. is a section diagram of a preferable embodiment of the invention.

As shown in FIG.1, the printed circuit board (PCB) is a rigid PCB and includes sequentially crossing laminated three insulating layers 110 clad with copper circuit layers and two solidified insulating layers 120, wherein top and bottom of the PCB are both the insulating layers 110 clad with copper circuit layers. The top and bottom surfaces of the insulating layer 110 are both clad with copper circuit layers 130. The PCB also includes two cylindrical insulated micro radiators 150 respectively embedded in two cylindrical through holes of the PCB. The height of the insulated micro radiator 150, with top and bottom surfaces both clad with copper patterns 151, is equal to the thickness of the PCB. One LED chip 160 is provided on the top copper pattern 151 respectively. The power inputs (not shown in figures) of LED chip 160 and inner circuit layers of the PCB are electrically connected. The bottom copper pattern 151 of the insulated micro radiator 150 is electrically insulated from the copper circuit layers of the PCB.

The insulated micro radiator 150 is made of electrical insulating materials with high thermal conductivity of alumina ceramic, aluminum nitride ceramic, silicon carbide, diamond, etc. The thermal conductivity between top and bottom copper patterns 151 of the insulated micro radiator 150 can be as high as 20-1000W/mk.

In the process of the operation of the PCB, LED chip 160 is switched on and emits light and generates heat. The heat is transmitted from top copper pattern 151, through the insulated micro radiator 150, to the bottom copper pattern 151, and then to the outer side of the PCB.

The PCB of the invention is not just limited to the abovementioned preferable embodiments. The equal variants and modifications of the invention are all covered within the scope of the claims of the invention. For example:
The top copper pattern 151 of the insulated micro radiator 150 embedded in the PCB is also provided with one or a number of heating components including LEDs or other Integrated Circuit components;
The rigid PCB of the preferable embodiment can connect with a conventional flexible PCB and becomes a rigid-flexible PCB;
The PCB is not just limited to the six-layer PCB with six copper circuit layers but can also be a multi-layer PCB, such as a four-layer PCB, an eight-layer PCB, a sixteen-layer PCB and so on.

The insulating layer 110 clad with copper circuit layers is not limited to have two surfaces clad with copper circuit layers but it can also have only one surface clad with a copper circuit layer, but top and bottom surfaces of the PCB are both required to be clad with copper circuit layers.

The shape of the insulated micro radiator is not limited to be cylindrical shape and it can also be in elliptic cylinder shape, cube shape, cylinder shape with its top and bottom surfaces both in diamond shape, triangular shape, trapezoidal shape, etc.

The quantity of the insulated micro radiators provided on the PCB can be one or more than one, according to the needs of an actual design.

One LED component or other Integrated Circuit component provided on the insulated micro radiator is not only limited to be electrically connected with the inner circuit layers of the PCB but can also be electrically connected with top circuit layer and/or bottom circuit layer of the PCB.

## Claims

1. A printed circuit board (PCB) with an insulated micro radiator, comprising a PCB substrate including sequentially crossing laminated multi insulating layers clad with copper circuit layers and multi solidified insulating layers, wherein the PCB with the insulated micro radiator further comprises a cylindrical insulated micro radiator embedded in a cylindrical through hole of the PCB substrate; the height of the insulated micro radiator, with top and bottom surfaces both clad with copper patterns, is equal to the thickness of the PCB substrate, wherein the top copper pattern is provided with a heating component, and the bottom copper pattern is insulated from the copper circuit layers of the PCB.

2. The PCB with the insulated micro radiator according to claim 1, wherein the insulated micro radiator is made of electrical insulating materials of alumina ceramic, aluminum nitride ceramic, silicon carbide, diamond, etc.

3. The PCB with the insulated micro radiator according to claim 1 or 2, wherein the insulated micro radiator is in elliptic cylinder shape, cube shape, or cylinder shape with its top and bottom surfaces both in diamond shape, triangular shape or trapezoidal shape.

4. The PCB with the insulating micro radiator according to claim 1, wherein there are one or a number of the insulated micro radiators on the PCB.

5. The PCB with the insulated micro radiator according to claim 1, wherein the heating component is an LED chip.

6. The PCB with the insulated micro radiator according to claim 1, wherein the heating component is an LED component.

7. The PCB with the insulated micro radiator according to claim 1, wherein the insulating layer clad with copper circuit layers has its one surface clad with a copper circuit layer.

8. The PCB with the insulated micro radiator according to claim 1, wherein the insulating layer clad with copper circuit layers has its two surfaces clad with copper circuit layers.

9. The PCB with the insulated micro radiator according to claim 1, wherein the heating component and the copper circuit layers are electrically connected.

10. The PCB with the insulated micro radiator according to claim 1, wherein the PCB is a four-layer PCB, six-layer PCB, eight-layer PCB or sixteen-layer PCB.
